(19) Europäisches Patentamt
European Patent Office
Office européen des brevets

(11) **EP 3 837 587 B1**

(12) **EUROPÄISCHE PATENTSCHRIFT**

(45) Veröffentlichungstag und Bekanntmachung des Hinweises auf die Patenterteilung:
**17.04.2024 Patentblatt 2024/16**

(21) Anmeldenummer: **19739925.6**

(22) Anmeldetag: **28.06.2019**

(51) Internationale Patentklassifikation (IPC):
**G03H 5/00** (2006.01)   **G03H 1/22** (2006.01)
**G01R 31/305** (2006.01)   **H01J 37/26** (2006.01)
**G03H 1/00** (2006.01)

(52) Gemeinsame Patentklassifikation (CPC):
**G03H 5/00; G03H 1/22;** G01R 31/305;
G03H 2001/0033; G03H 2210/12; G03H 2224/04;
G03H 2226/02; G03H 2226/11; H01J 37/266

(86) Internationale Anmeldenummer:
**PCT/EP2019/067425**

(87) Internationale Veröffentlichungsnummer:
**WO 2020/035205 (20.02.2020 Gazette 2020/08)**

(54) **ANORDNUNG UND VERFAHREN ZUM ERFASSEN EINES MESSWERTES AUF DER BASIS VON ELEKTRONENHOLOGRAPHIE**

ASSEMBLY AND METHOD FOR DETECTING A MEASURED VALUE BASED ON ELECTRON HOLOGRAPHY

DISPOSITIF ET PROCÉDÉ DE DÉTECTION D'UNE VALEUR MESURÉE À BASE DE L'HOLOGRAPHIE ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.08.2018 EP 18188717**

(43) Veröffentlichungstag der Anmeldung:
**23.06.2021 Patentblatt 2021/25**

(73) Patentinhaber: **Technische Universität Berlin
10623 Berlin (DE)**

(72) Erfinder:
• WAGNER, Tolga
  13507 Berlin (DE)
• LEHMANN, Michael
  12557 Berlin (DE)
• NIERMANN, Tore
  10823 Berlin (DE)

(74) Vertreter: **Fischer, Uwe
Patentanwalt
Moritzstraße 22
13597 Berlin (DE)**

(56) Entgegenhaltungen:
• NIERMANN T ET AL: "Gated interference for time-resolved electron holography", ULTRAMICROSCOPY, Bd. 182, 19. Juni 2017 (2017-06-19), Seiten 54-61, XP085204034, ISSN: 0304-3991, DOI: 10.1016/J.ULTRAMIC.2017.06.017 in der Anmeldung erwähnt
• MIGUNOV VADIM ET AL: "Prospects for quantitative and time-resolved double and continuous exposure off-axis electron holography", ULTRAMICROSCOPY, Bd. 178, 18. August 2016 (2016-08-18), Seiten 48-61, XP085014639, ISSN: 0304-3991, DOI: 10.1016/J.ULTRAMIC.2016.08.010
• GATEL C ET AL: "Dynamical holographic Moirés in a TEM", JOURNAL OF PHYSICS D: APPLIED PHYSICS, INSTITUTE OF PHYSICS PUBLISHING LTD, GB, Bd. 49, Nr. 32, 19. Juli 2016 (2016-07-19), Seite 324001, XP020307499, ISSN: 0022-3727, DOI: 10.1088/0022-3727/49/32/324001 [gefunden am 2016-07-19]

- **Tore Niermann ET AL: "Time-Resolved Electron Holography by Interference Gating", Microscopy and Microanalysis, vol. 24, no. S1, 6 August 2018 (2018-08-06), pages 1874-1875, XP055539902, ISSN: 1431-9276, DOI: 10.1017/S1431927618009856**
- **Daisuke Shindo ET AL: "Advanced Electron Holography Applied to Electromagnetic Field Study in Materials Science", Advanced Materials, vol. 29, no. 25, 1 July 2017 (2017-07-01), page 1602216, XP055540315, DE ISSN: 0935-9648, DOI: 10.1002/adma.201602216**
- **TOSHIAKI TANIGAKI ET AL: "New trend in electron holography", JOURNAL OF PHYSICS D: APPLIED PHYSICS, INSTITUTE OF PHYSICS PUBLISHING, BRISTOL, GB, vol. 49, no. 24, 12 May 2016 (2016-05-12), page 244001, XP020306186, ISSN: 0022-3727, DOI: 10.1088/0022-3727/49/24/244001 [retrieved on 2016-05-12]**
- **NIERMANN T ET AL: "Gated interference for time-resolved electron holography", ULTRAMICROSCOPY, vol. 182, 2017, pages 54-61, XP085204034, ISSN: 0304-3991, DOI: 10.1016/J.ULTRAMIC.2017.06.017**
- **MIGUNOV VADIM ET AL: "Prospects for quantitative and time-resolved double and continuous exposure off-axis electron holography", ULTRAMICROSCOPY, vol. 178, 2016, pages 48-61, XP085014639, ISSN: 0304-3991, DOI: 10.1016/J.ULTRAMIC.2016.08.010**

**Beschreibung**

Die Erfindung bezieht sich auf ein Verfahren zum Erfassen eines Messwertes unter Einbezug zumindest eines Elektronenholographiemessschrittes.

Aus der Druckschrift "Gated interference for time-resolved electron holography" (T. Niermann, M. Lehmann, und T. Wagner, Ultramicroscopy 182 (2017) 54-61) ist ein zeitaufgelöstes E-lektronenholographiemessverfahren bekannt, bei dem ein rechteckförmiges Anregungssignal an einem Eingang eines Bauelements eingespeist wird. Ein durch Interferenz zweier Elektronenstrahlen während eines vorgegebenen Messfensters entstehendes Elektronenhologramm wird gemessen und daraus ein Phasenbild ermittelt; anhand des Phasenbildes wird ein Messwert gebildet.

Aus der Druckschrift "Prospects for quantitative and time-resolved double and continuous exposure off-axis electron holography" (V. Migunov et al., Ultramicroscopy 178 (2016) 48-61) ist ein nichtzeitaufgelöstes Elektronenholographiemessverfahren bekannt, bei dem ein Messfenster eine zeitliche Länge im Sekundenbereich aufweist und zu einer Mittelung über Millionen von Perioden des Anregungssignals führt.

Der Erfindung liegt die Aufgabe zugrunde, ein Messverfahren anzugeben, das in relativ einfacher Weise auch für sehr kleine Bauelemente, die nur eingeschränkt zugänglich sind, zeitaufgelöste Messwerte in Abhängigkeit von der Frequenz des elektrischen Anregungssignals des Bauelements liefern kann.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Ein wesentlicher Vorteil des erfindungsgemäßen Verfahrens ist darin zu sehen, dass die zeitliche Länge der Elektronenholographiemessschritte bzw. die zeitliche Länge der Messfenster bei jedem Elektronenholographiemessschritt jeweils an die Periodendauer des sinusförmigen Anregungssignals angepasst wird, und zwar dergestalt, dass die Messfensterlänge stets kleiner ist als die Hälfte der Periodendauer. Durch diese Dimensionierung der Messfensterlänge lässt sich erreichen, dass das Phasenbild stets zur Bildung des Messwertes herangezogen werden kann, beispielsweise indem die Änderung der Phase über dem Ort quantitativ ausgewertet wird.

Ein weiterer wesentlicher Vorteil des erfindungsgemäßen Verfahrens ist darin zu sehen, dass das Verfahren das Messen elektrischer oder magnetischer Feldstärken, elektrischer Spannungen oder elektrischer Ströme, in Abhängigkeit von der Frequenz des elektrischen Anregungssignals des Bauelements, auch für sehr kleine Bauelemente ermöglicht, die von außen nur schwer zugänglich sind und beispielsweise selbst nicht kontaktiert werden können.

Mit Blick auf eine Charakterisierung des Bauelements für unterschiedliche Frequenzen, insbesondere für die Ermittlung eines Frequenzganges des Bauelements, ist, entsprechend der beanspruchten Erfindung, vorgesehen, dass zumindest zwei Elektronenholographiemessschritte der beschriebenen Art nacheinander mit unterschiedlichen Anregungsfrequenzen durchgeführt werden.

Vorteilhaft ist es, wenn die Lage des Messfensters relativ zu den Stellen maximaler Steigung des Anregungssignals derart gewählt wird, dass das Messfenster zwischen diesen Stellen liegt und diese nicht einschließt. Bei dieser Ausgestaltung lassen sich besonders ungestörte Phasenbilder erzielen, die besonders einfach auswertbar sind.

Wird in das Bauelement ein sinusförmiges Anregungssignal ohne überlagerten Gleichanteil eingespeist, so ist es also vorteilhaft, wenn die Lage des Messfensters relativ zu den Nulldurchgängen derart gewählt wird, dass das Messfenster zwischen den Nulldurchgängen liegt und diese nicht einschließt.

Besonders vorteilhaft ist es, wenn die Lage des Messfensters derart gewählt wird, dass es eine Extremstelle, also entweder ein Maximum oder ein Minimum, des Anregungssignals erfasst. In den Bereichen einer Extremstelle ist das Anregungssignal zeitlich relativ konstant und ermöglicht somit besonders genaue Messergebnisse.

Die Lage des Messfensters wird vorzugsweise derart gewählt, dass die Fenstermitte an der oder zumindest im Bereich der Extremstelle des Anregungssignals liegt.

Vorzugsweise liegt die Fenstermitte stets an der oder zumindest im Bereich der ausgewählten Extremstelle des Anregungssignals.

Auch wird es als vorteilhaft angesehen, wenn anhand des Phasenbildes die Änderung der Phase über dem Ort unter Bildung eines Steigungswerts (also durch Ableitung der Phase nach dem Ort) ermittelt wird und als der Messwert der Steigungswert ausgegeben wird oder mit dem Steigungswert der Messwert gebildet wird, insbesondere durch Multiplikation mit einer Konstante.

Als Messwert wird vorzugsweise die an dem Bauelement anliegende elektrische Spannung oder der durch das Bauelement fließende Strom ermittelt. Alternativ oder zusätzlich können Feldstärken elektrischer oder magnetischer Felder gemessen werden.

Es werden Bauteile vermessen bzw. charakterisiert, die auf ein elektrisches Anregungssignal, reagieren und eine Eigenschaft in Abhängigkeit von dem Anregungssignal in messbarem Umfange verändern. Als Bauteile können also beispielsweise Kapazitäten, elektronische Bauelemente, Kabel, elektrische Geräte, elektrochemische Zellen vermessen und durch Messwerte charakterisiert werden.

Die zeitliche Länge des Messfensters ist vorzugsweise kleiner als ein Fünftel der Periodendauer des Anregungssignals, insbesondere kleiner als ein Achtel, vorzugsweise kleiner als ein Zehntel und besonders bevorzugt kleiner als ein Zwanzigstel der Periodendauer des Sinussignals. Je kürzer die Länge des Messfensters ist, umso konstanter ist das Anregungssignal in dem Messfenster, jedoch wird das Phasenbild wegen der Kürze der Messzeit immer grobkörniger und die Auswertbarkeit verschlechtert sich. Der Bereich zwischen 1/5 und 1/100 der Periodendauer des Sinussignals stellt für die zeitliche Länge des Messfensters somit ein Optimum dar.

Bezüglich der Ermittlung eines Frequenzgangs, entsprechend einer vorteilhaften Ausgestaltung der beanspruchten Erfindung, wird eine Vielzahl an Elektronenholographiemessschritten der beschriebenen Art nacheinander mit unterschiedlichen Anregungsfrequenzen durchgeführt und in jedem Elektronenholographiemessschritt jeweils ein Verhältniswert zwischen der Amplitude des sinusförmigen Anregungssignals und dem Messwert errechnet und mit den Verhältniswerten ein Frequenzgang des Bauelements ermittelt.

Darüber hinaus ist es von Vorteil, wenn die Lage des Messfensters, insbesondere die Lage der Fenstermitte, relativ zu den Stellen maximaler Änderung der Phase derart gewählt wird, dass das Messfenster an diesen oder zumindest im Bereich dieser Stellen liegt.

Die Erfindung bezieht sich darüber hinaus auf eine Anordnung zum Erfassen eines Messwertes. Erfindungsgemäß weist die Anordnung die Merkmale gemäß Patenanspruch 10 auf.

Bezüglich der Vorteile der erfindungsgemäßen Anordnung sei auf die obigen Ausführungen im Zusammenhang mit dem erfindungsgemäßen Verfahren verwiesen.

Die Messfenstersteuereinheit ist vorzugsweise derart ausgebildet ist, dass sie

- die Lage des Messfensters relativ zu den Stellen maximaler Steigung des Anregungssignals derart wählt, dass das Messfenster zwischen diesen Stellen liegt und diese nicht einschließt, und/oder
- die Lage des Messfensters derart wählt, dass das Messfenster eine Extremstelle, also entweder ein Maximum oder ein Minimum, des Anregungssignals erfasst, und/oder
- die Lage des Messfensters derart wählt, dass die Fenstermitte an der oder zumindest im Bereich einer Extremstelle des Anregungssignals liegt, und/oder
- die Lage des Messfensters derart wählt, dass das Messfenster an mehreren äquidistanten Stellen, zumindest jedoch vier äquidistanten Stellen des Anregungssignals liegt, um mehrere, zumindest aber vier, Elektronenholographiemessschritte nacheinander bei gleichen Periodenlängen des Anregungssignals durchzuführen.

Die Auswerteinheit ist vorzugsweise derart ausgebildet, dass sie anhand des Phasenbildes die Änderung der Phase über dem Ort unter Bildung eines Steigungswerts ermittelt und als Messwert den Steigungswert ausgibt oder mit dem Steigungswert den Messwert bildet, insbesondere durch Multiplikation mit einer Konstante.

Eine Sortiereinheit der Anordnung ist vorzugsweise derart ausgebildet, dass sie Steigungswerte nach dem betragsmäßig höchsten Steigungswert sortiert und mit diesem betragsmäßig höchsten Steigungswert den Messwert bildet, insbesondere durch Multiplikation mit einer Konstante.

Die Erfindung wird nachfolgend anhand von Ausführungsbeispielen näher erläutert; dabei zeigen beispielhaft

Figur 1      ein Ausführungsbeispiel für eine erfindungsgemäße Anordnung zum Erfassen eines Messwertes,

Figur 2      ein Ausführungsbeispiel für ein Bauelement, an dem eine Spannung anliegt, deren Höhe mit der Anordnung gemäß Figur 1 gemessen werden kann,

Figur 3      ein Elektronenmikroskopiebild des Bauelements gemäß Figur 2,

Figur 4      ein Ausführungsbeispiel für ein Anregungssignal, das von einem Sinusgenerator der Anordnung gemäß Figur 1 erzeugt werden kann,

Figur 5      ein Ausführungsbeispiel für ein Elektronenhologramm, das von einem Elektronenholographiemessgerät der Anordnung gemäß Figur 1 für das Bauelement gemäß den Figuren 2 und 3 erzeugt worden ist, und zwar für eine Anregungsfrequenz von 1 kHz,

Figur 6      ein Ausführungsbeispiel für ein aus dem Elektronenhologramm gemäß Figur 5 rekonstruiertes Phasenbild, anhand dessen ein Messwert, hier ein Messwert für die an dem Bauelement gemäß den Figuren 2 und 3 bei der Anregungsfrequenz von 1 kHz anliegende Bauelementspannung, ermittelt worden ist,

Figur 7      ein aus einem Elektronenhologramm bei einer Anregungsfrequenz von 3 MHz rekonstruiertes Phasenbild, anhand dessen ein Messwert für die an dem Bauelement gemäß den Figuren 2 und 3 bei dieser Anregungsfrequenz anliegende Bauelementspannung ermittelt worden ist, und

Figur 8      ein weiteres Ausführungsbeispiel für ein Anregungssignal, das von einem Sinusgenerator der Anordnung gemäß Figur 1 erzeugt werden kann,

Figur 9      ein Ausführungsbeispiel für eine alternative erfindungsgemäße Anordnung zum Erfassen eines Messwertes,

Figur 10   ein Ausführungsbeispiel für eine Analyse der Steigungswerte bei äquidistanten Messfensterpositionen zur Ermittlung des betragsmäßig höchsten Steigungswertes durch eine Sortiereinheit der Anordnung gemäß Figur 9.

In den Figuren werden der Übersicht halber für identische oder vergleichbare Komponenten stets dieselben Bezugszeichen verwendet.

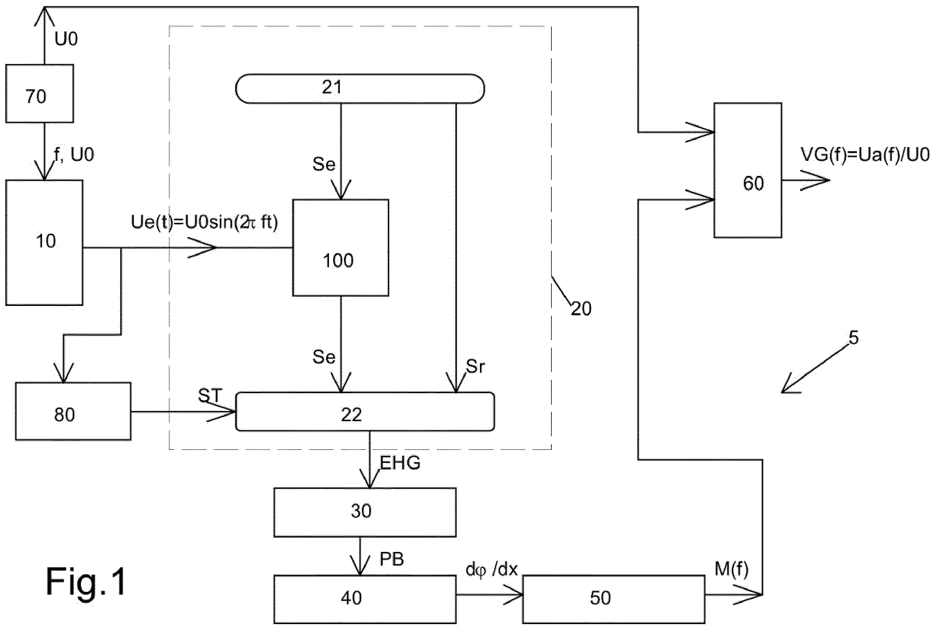

Die Figur 1 zeigt ein Ausführungsbeispiel der beanspruchten Erfindung für eine Anordnung 5 zum Erfassen eines Messwerts. Die Anordnung 5 weist einen Sinusgenerator 10 auf, der ein sinusförmiges elektrisches Anregungssignal Ue erzeugt gemäß

$$Ue(t) = U0 \ sin(2\pi \ f \ t)$$

wobei U0 die Signalamplitude des Anregungssignals, f die Anregungsfrequenz des Anregungssignals und t die Zeit bezeichnet.

Mit dem sinusförmigen Anregungssignal Ue wird ein Bauelement 100 beaufschlagt. Das Bauelement 100 befindet sich in einem Elektronenholographiemessgerät 20, das unter anderem eine Elektronenquelle 21 und eine Messeinheit 22 umfasst. Bei dem Elektronenholographiemessgerät 20 kann es sich beispielsweise um das in der Druckschrift "Gated interference for time-resolved electron holography" (T. Niermann, M. Lehmann, und T. Wagner, Ultramicroscopy 182 (2017) 54-61) beschriebene Gerät handeln.

Die Elektronenquelle 21 erzeugt einen Elektronenstrahl Se, der das Bauelement 100 durchdringt und/oder passiert und anschließend mit einem Referenzelektronenstrahl Sr überlagert wird. Die Elektronenstrahlen interferieren und bilden ein Elektronenhologramm EHG, das von der Messeinheit 22 des Elektronenholographiemessgeräts 20 gemessen und ausgangsseitig ausgegeben wird. Bei der Messeinheit 22 kann es sich, wie in der genannten Druckschrift "Gated interference for time-resolved electron holography", beispielsweise um ein Biprisma handeln; alternativ kann jedes andere Mittel, mit dem sich ein zeitlich begrenztes Messfenster erzeugen lässt, eingesetzt werden, wie beispielsweise eine ausreichend schnell arbeitende Kamera, eine Stroboskopeinrichtung oder eine Strahlabschattungseinrichtung (Shutter).

An die Messeinheit 22 des Elektronenholographiemessgeräts 20 ist eine Phasenbilderzeugungseinheit 30 angeschlossen, die aus dem Elektronenhologramm EHG ein Phasenbild PB rekonstruiert und ausgangsseitig an eine nachgeordnete Auswerteinheit 40 ausgibt. Die Auswerteinheit 40 kann anhand des Phasenbildes PB die Änderung der Phase φ über dem Ort x

unter Bildung eines Steigungswerts dφ/dx ermitteln. Dieser Steigungswert dφ/dx kann unmittelbar als Messwert der Anordnung 5 ausgegeben werden oder stattdessen - wie beispielhaft in der Figur 1 gezeigt - in einen nachgeordneten Multiplizierer 50 eingespeist werden, der den Steigungswert dφ/dx mit einer Konstante K multipliziert und durch diese Multiplikation einen Messwert M erzeugt, der die an dem Bauelement 100 anliegende Bauelementspannung Ua angibt.

Der Messwert M bzw. die Bauelementspannung Ua, der im Allgemeinen von der Frequenz f des Anregungssignals Ue abhängig ist, gelangt zu einem nachgeordneten Quotientenbilder 60, der einen Frequenzgang VG(f) des Bauelements 100 ermittelt.

Die Anordnung 5 weist darüber hinaus eine Steuereinrichtung 70 auf, die den Sinusgenerator 10 ansteuert und ihm für die Durchführung eines jeden Elektronenholographiemessschritts die Signalamplitude U0 und die Anregungsfrequenz f vorgibt. Der Sinusgenerator 10 erzeugt das Anregungssignal Ue also unter Berücksichtigung der von der Steuereinrichtung 70 erhaltenen Vorgaben.

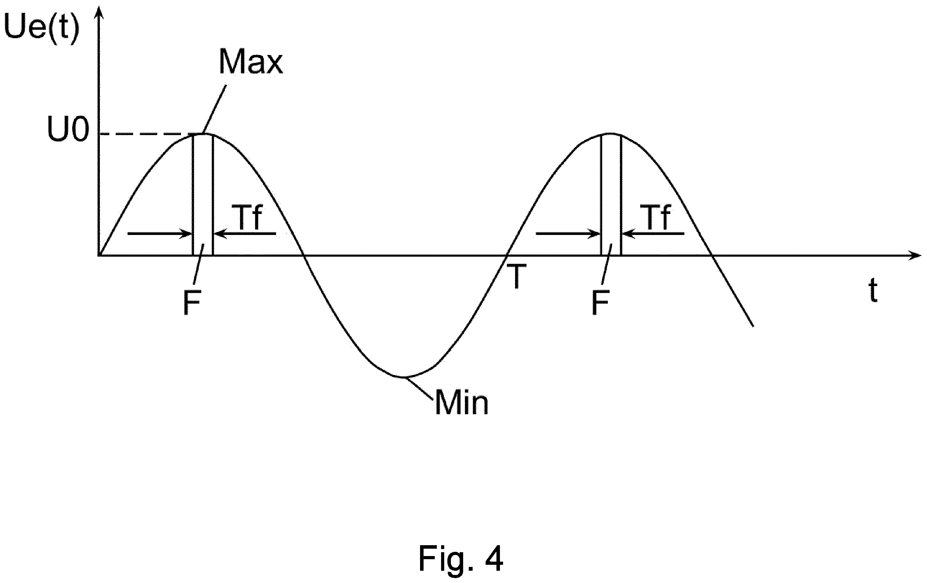

Zur Ansteuerung der Messeinheit 22 des Elektronenholographiemessgeräts 20 weist die Anordnung 5 eine Messfenstersteuereinheit 80 auf, die die zeitliche Länge Tf des Messfensters F (vgl. Figur 4) sowie die zeitliche Lage des Messfensters F relativ zum zeitlichen Verlauf des Anregungssignals Ue festlegt. Die Festlegung wird beispielhaft weiter unten im Zusammenhang mit der Figur 4 erläutert.

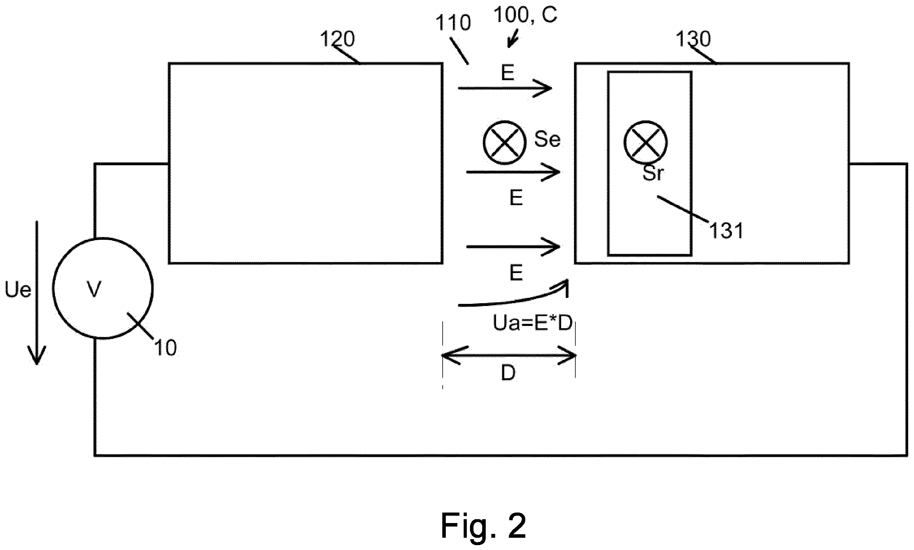

Ein Ausführungsbeispiel für das Bauelement 100 gemäß Figur 1 ist in einer schematischen Draufsicht näher in Figur 2 gezeigt. Bei dem Bauelement 100 handelt es sich um eine Kapazität C, die durch einen Spalt 110 zwischen einer in der Figur 2 linken Leiterbahn 120 und einer in der Figur 2 rechten Leiterbahn 130 gebildet ist. Der Sinusgenerator 10 gemäß Figur 1 ist an die zwei Leiterbahnen 120 und 130 angeschlossen und beaufschlagt die Reihenschaltung aus den zwei Leiterbahnen 120 und 130 und der Kapazität C mit dem Anregungssignal Ue.

Zur Messung der Spannung an der Kapazität C wird der Elektronenstrahl Se durch den Spalt 110 zwischen den zwei Leiterbahnen 120 und 130 gestrahlt, so dass dieser mit dem elektrischen Feld E bzw. dem elektrischen Potenzial zwischen den zwei Leiterbahnen 120 und 130 beaufschlagt wird. Die an dem Spalt 110 und damit an der Kapazität C abfallende Bauelementspannung ist mit dem Bezugszeichen Ua gekennzeichnet und ergibt sich wie folgt:

$$Ua = E * D$$

wobei D die Breite des Spalts 110 kennzeichnet.

Um zu gewährleisten, dass der Referenzelektronenstrahl Sr das Bauelement 100 bzw. die Kapazität C ungestört passieren kann und von dem dort anliegenden Feld E nicht beeinflusst wird, ist die in der Figur 2 rechte Leiterbahn 130 mit einer Ausnehmung 131 versehen, die ein ungestörtes Passieren des Referenzelektronenstrahls Sr ermöglicht.

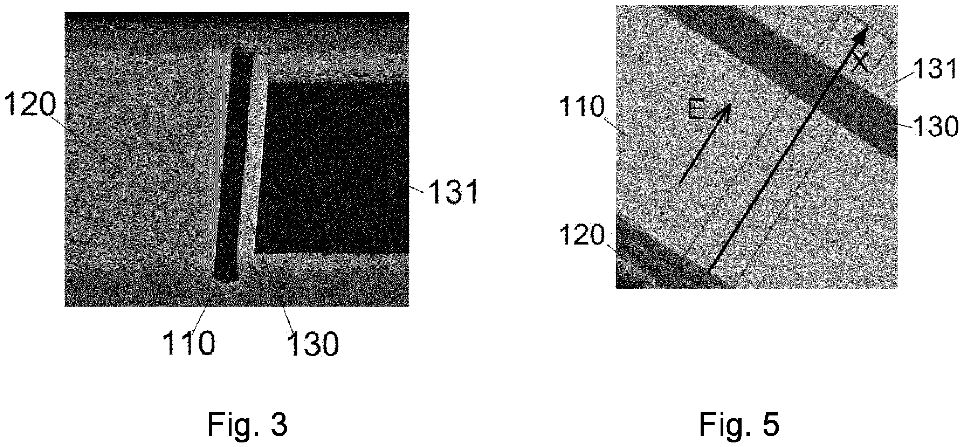

Die Figur 3 zeigt die beiden Leiterbahnen 120 und 130 sowie den dazwischen befindlichen Spalt 110 in Form einer Aufnahme, die von einem Elektronenmikroskop erzeugt worden ist. Die Spaltbreite D des Spalts 110 kann beispielsweise 3 μm betragen.

Die Anordnung 5 gemäß Figur 1 kann beispielsweise wie folgt betrieben werden:
Der Sinusgenerator 10 erzeugt ausgangsseitig das Anregungssignal Ue und speist dieses in das Bauelement 100 ein. Die Amplitude U0 und die Frequenz f des Anregungssignals Ue werden von der Steuereinrichtung 70 vorgegeben. Für jeden Elektronenholographiemessschritt kann jeweils individuell eine Frequenz f vorgegeben werden; während einer Messung mit mehreren Elektronenholographiemessschritten, entsprechend der beanspruchten Erfindung, kann also bei jedem Schritt jeweils eine andere Anregungsfrequenz f eingestellt werden und so ein Frequenzgang VG(f) eines Bauelements gemessen werden.

Aufgrund des Anregungssignals Ue entsteht im Spalt 110 zwischen den Leiterbahnen 120 und 130 das elektrische Feld E, das den Elektronenstrahl Se beeinflusst; der Referenzelektronenstrahl Sr bleibt davon unbeeinflusst.

Die Messeinheit 22 des Elektronenholographiemessgerätes 20 wird von der Messfenstersteuereinheit 80 angesteuert, und zwar dass die Lage eines jeden Messfensters F während eines jeden Elektronenholographiemessschritts an die jeweilige Anregungsfrequenz f des Anregungssignals Ue anpasst ist. Hierzu erzeugt die Messfenstersteuereinheit 80 ausgangsseitig ein Steuersignal ST, das die zeitliche Länge Tf sowie die zeitliche Lage des Messfensters F relativ zum zeitlichen Verlauf des Anregungssignals Ue festlegt. Dies wird nachfolgend näher im Zusammenhang mit der Figur 4 erläutert. Unter dem Begriff Messfenster ist hier diejenige Zeitspanne zu verstehen, in der jeweils ein Elektronenhologramm EHG aufgenommen wird.

Die Figur 4 zeigt ein Ausführungsbeispiel für ein Anregungssignal Ue, das von dem Sinusgenerator 10 zur Ansteuerung des Bauelements 100 erzeugt werden kann. Es lässt sich erkennen, dass die Messfenstersteuereinheit 80 die zeitliche Länge Tf des Messfensters F derart klein wählt, dass diese stets kleiner ist als die Hälfte der Periodendauer T des Anregungssignals Ue. Besonders vorteilhaft ist es, wenn die Länge Tf des Messfensters F maximal 5 % der Periodendauer T des Anregungssignals Ue beträgt und bei jedem Elektronenholographiemessschritt die Lage des Messfensters - bezogen auf die gewählte Extremstelle (Maximum oder Minimum)-jeweils gleich ist.

Darüber hinaus sorgt die Messfenstersteuereinheit 80 dafür, dass die Lage des Messfensters F derart gewählt wird, dass das Messfenster F im Bereich einer Extremstelle des Anregungssignals Ue liegt. Bei dem Ausführungsbeispiel gemäß Figur 4 liegt das Messfenster F im Bereich eines Maximums Max des Anregungssignals Ue. Besonders vorteilhaft ist es, wenn die Fenstermitte des Fensters F mit der gewählten Extremstelle, bei dem Ausführungsbeispiel gemäß Figur 4 also dem Maximum Max, zusammenfällt.

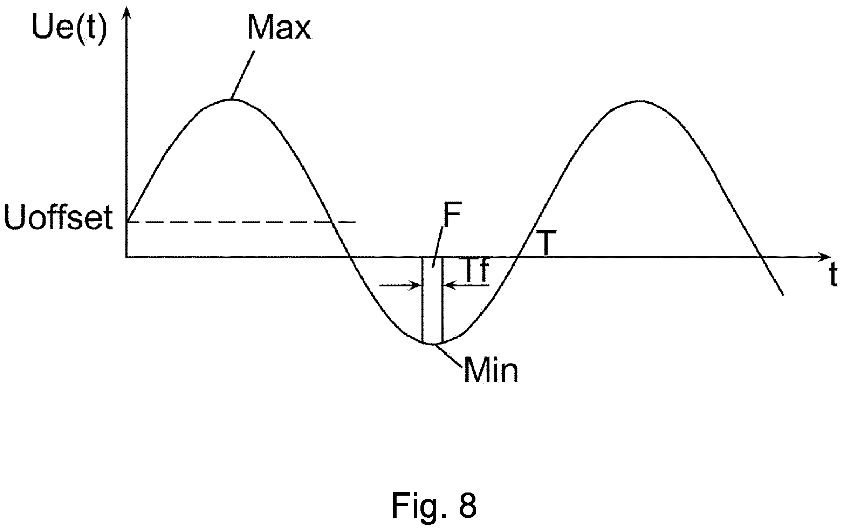

Die Auswahl des Maximums Max als Extremstelle ist bei dem Ausführungsbeispiel gemäß Figur 4 nur beispielhaft zu verstehen; statt des Maximums kann das Messfenster F auch im Bereich eines Minimums Min des Anregungssignals Ue liegen, wie weiter unten im Zusammenhang mit der Figur 8 erläutert wird. Auch muss das Anregungssignal Ue nicht zwingend allein sinusförmig sein, stattdessen kann auch ein Gleichanteil überlagert sein; auch dies wird weiter unten im Zusammenhang mit der Figur 8 erläutert.

Die Figur 5 zeigt ein Ausführungsbeispiel für ein Elektronenhologramm EHG, das von der Messeinheit 22 des Elektronenholographiemessgerätes 20 erfasst wird. Die Figur 5 zeigt in einer Draufsicht die beiden Leiterbahnen 120 und 130, den Spalt 110 zwischen den Leiterbahnen sowie darüber hinaus die Ausnehmung 131 in der Leiterbahn 130. Der in der Figur 5 die X-Koordinate angebende Pfeil erstreckt sich also von der Leiterbahn 120 durch den Spalt 110 bis in den Bereich der Ausnehmung 131 der Leiterbahn 130 hinein.

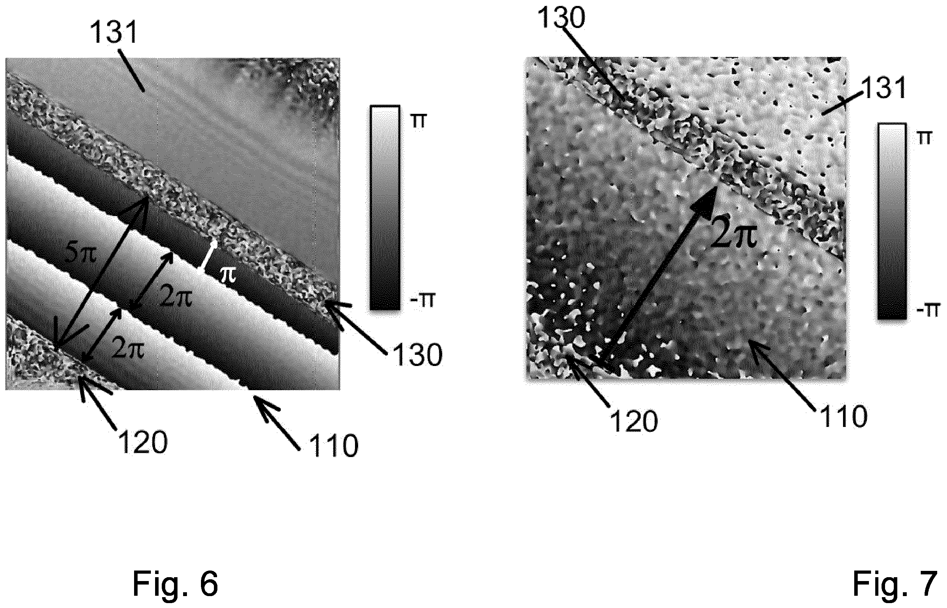

Das Elektronenhologramm EHG wird von der Phasenbilderzeugungseinheit 30 gemäß Figur 1 ausgewertet und es wird ein Phasenbild PB extrahiert, das für eine Amplitude U0 des Anregungssignals Ue von beispielsweise 0,5 V in der Figur 6 näher gezeigt ist. Es lässt sich erkennen, dass im Spalt 110 zweieinhalb Phasensprünge auftreten, also zwischen den zwei Leiterbahnen 120 und 130 ein Phasenversatz von insgesamt 5 π auftritt.

Die Auswerteinheit 40 kann unter Berücksichtigung der Spaltbreite D von 3 μm zwischen den zwei Leiterbahnen 120 und 130 nun die Änderung der Phase über dem Ort unter Bildung eines Steigungswertes dφ/dx ermitteln, und zwar gemäß:

$$d\varphi/dx = 5\pi/D = 5{,}2 \ rad/\mu m.$$

Der Steigungswert dφ/dx kann unmittelbar als Messwert der Anordnung 5 ausgegeben werden. Alternativ oder zusätzlich kann - wie bei dem Ausführungsbeispiel gemäß Figur 1 - der Steigungswert dφ/dx an den Multiplizierer 50 weitergegeben werden, der den Steigungswert dφ/dx mit einer für das Elektronenholographiemessgerät 20 ermittelten Konstante K multipliziert und ausgangsseitig einen Messwert erzeugt, der die an der Kapazität C gemäß Figur 2 anliegende Bauelementspannung Ua angibt gemäß

$$Ua = K * d\varphi/dx.$$

Die Konstante K kann beispielsweise unter Heranziehung von Referenzmessungen mit anderen Messeinrichtungen ermittelt werden. Beispielsweise kann die Spannung an der Kapazität C vorher oder nachher mit einem anderen herkömmlichen Messgerät gemessen werden und das Messergebnis kann anschließend zur Kalibrierung des Elektronenholographiemessgeräts 20 bzw. zur Bestimmung der Konstante K genutzt werden.

Für die in den Figuren 6 und 7 gezeigten Phasenbilder wurde ein Elektronenholographiemessgerät 20 verwendet, bei dem die Konstante K von 0,0962 Vpm/rad beträgt, so dass sich aus dem obigen Steigungswert dφ/dx von 5,2 rad/um eine Bauelementspannung Ua von 0,5 V ergibt.

In der beschriebenen Weise kann eine Vielzahl an Elektronenholographiemessschritten, entsprechend der beanspruchten Erfindung, für unterschiedliche Anregungsfrequenzen f durchgeführt werden, die von der Steuereinrichtung 70 vorgegeben werden.

Bei dem Ausführungsbeispiel gemäß den Figuren 2 und 3 bildet die Kapazität C mit den Leiterbahnen 120 und 130 einen Tiefpass, so dass die an der Kapazität C anliegende Bauelementspannung Ua frequenzabhängig ist und mit höheren Frequenzen abnimmt. Es gilt hier

$$Ua = Ue/(2\pi f\ RC)$$

wobei R den Widerstand der beiden Leiterbahnen 120 und 130 und C die Kapazität bezeichnet.

Wird also die Anregungsfrequenz f im Anregungssignal Ue erhöht, so wird die Bauelementspannung Ua an der Kapazität C abfallen. Dieser Sachverhalt ist in der Figur 7 ersichtlich, bei der das Phasenbild für eine Messung mit einer höheren Anregungsfrequenz f von 3 MHz dargestellt ist. Es lässt sich erkennen, dass die Phasendifferenz φ zwischen den Leiterbahnen 120 und 130 nur noch $2\pi$ beträgt, also die Spannung Ua an der Kapazität C um den Faktor 2,5 kleiner ist als bei der Anregungsfrequenz von 1 kHz gemäß Figur 6.

Bei der Darstellung gemäß Figur 7 ist die Darstellung des Phasenbildes PB sehr viel grobkörniger als bei der Darstellung gemäß Figur 6, was damit zusammenhängt, dass die Anregungsfrequenz f des Anregungssignals Ue beim Elektronenholographiemessschritt gemäß Figur 7 deutlich größer ist als bei dem Elektronenholographiemessschritt gemäß Figur 6 und damit die zeitliche Länge des Messfensters Tf deutlich kleiner ist als bei dem Messschritt gemäß Figur 6. Im Falle mehrerer Elektronenholographiemessschritte nacheinander mit unterschiedlichen Periodenlängen T des Anregungssignals Ue, entsprechend der beanspruchten Erfindung, wird jeweils die zeitliche Länge Tf des Messfensters F an die jeweilige Periodenlänge T des Anregungssignals Ue angepasst, und zwar derart, dass das Verhältnis Tf/T zwischen der Länge Tf des Messfensters F und der jeweiligen Periodenlänge T des Anregungssignals Ue bei allen Elektronenholographiemessschritten gleich groß ist. Auch ist bei jedem Elektronenholographiemessschritt die Lage des Messfensters - bezogen auf das Maximum oder Minimum des sinusförmigen Anregungssignals-jeweils gleich; bevorzugt liegt die Fenstermitte eines jeden Messfensters jeweils bei allen Elektronenholographiemessschritten genau auf der ausgewählten Extremsstelle (Maximum oder Minimum) des Anregungssignals.

Durch Durchführung mehrerer Elektronenholographiemessschritte nacheinander mit unterschiedlichen Anregungsfrequenzen f, entsprechend der beanspruchten Erfindung, lässt sich somit der Frequenzgang VG(f) für die Spannung Ua an der Kapazität C angegeben gemäß

$$V(f) = Ua(f)/U0.$$

Die Figur 8 zeigt zur weiteren Erläuterung noch ein weiteres Ausführungsbeispiel für ein Anregungssignal Ue, das zur Anregung des Bauelements 100 während der Durchführung der Messung mittels der Anordnung 5 gemäß Figur 1 erzeugt werden kann. Es lässt sich erkennen, dass das Anregungssignal sinusförmig ist, jedoch um einen Gleichanteil Uoffset versetzt ist.

Darüber hinaus zeigt die Figur 8, dass die Messfenstersteuereinheit 80 das Messfenster F nicht zwingend in den Bereich des Maximums Max legen muss, alternativ kann sie das Messfenster F beispielsweise auch in den Bereich des Minimums Min des Anregungssignals Ue legen. Auch hier ist es vorteilhaft, wenn bei allen Elektronenholographiemessschritten unabhängig von der Anregungsfrequenz die Fenstermitte genau an der Extremstelle (hier also dem Minimum) liegt.

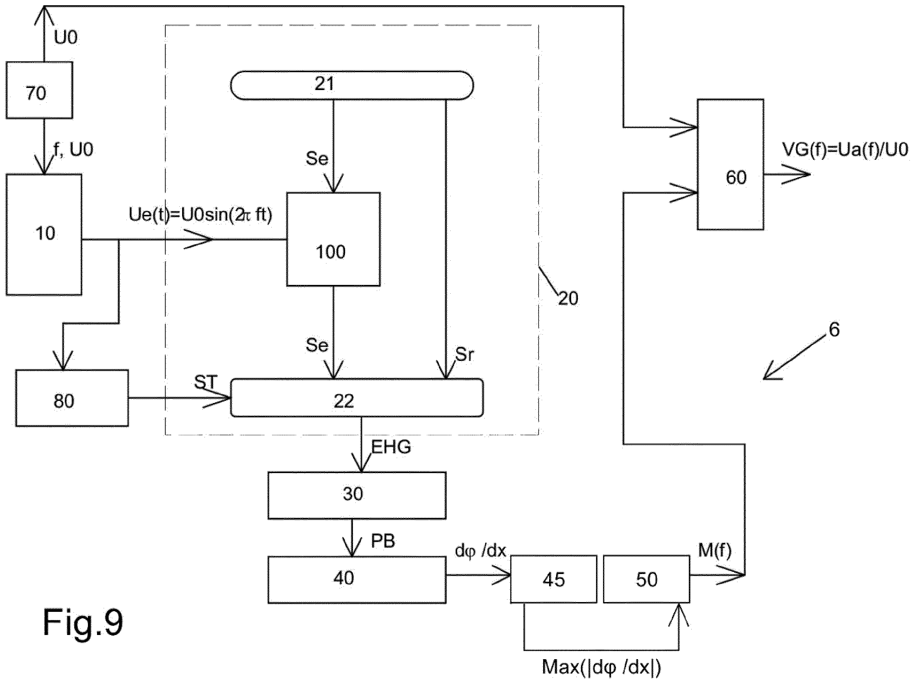

Die Figur 9 zeigt ein Ausführungsbeispiel der beanspruchten Erfindung für eine alternative Anordnung 6 zum Erfassen eines Messwerts. Die alternative Anordnung 6 stellt eine Abwandlung der Anordnung 5 gemäß Figur 1 dar, welche sich in zwei Punkten von der Anordnung 5 unterscheidet.

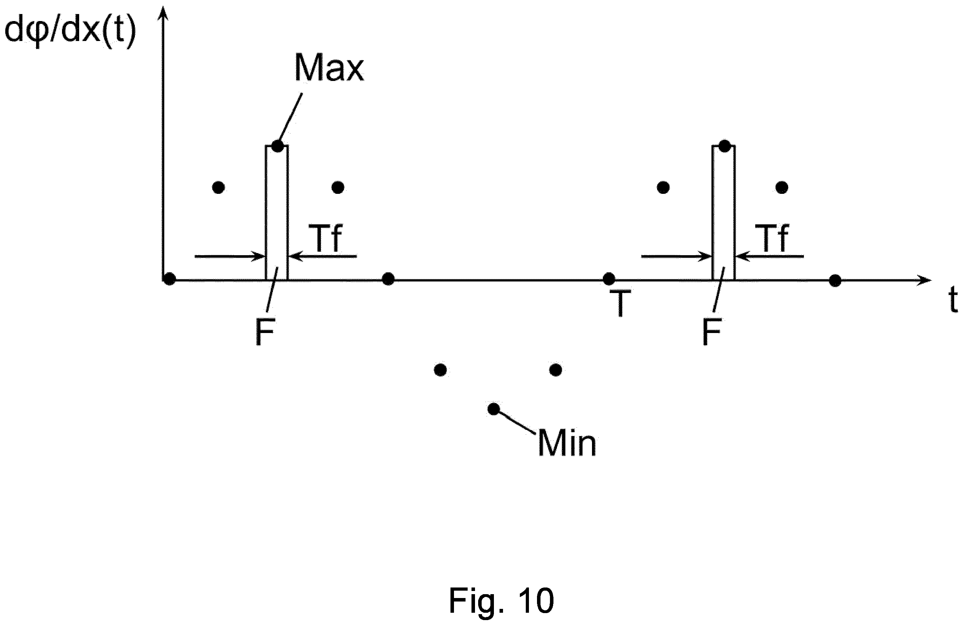

Die Messfenstersteuereinheit 80 wählt die Lage des Messfensters F derart, dass das Messfenster an mehreren äquidistanten Stellen, zumindest jedoch vier äquidistanten Stellen des Anregungssignals liegt, um mehrere, zumindest aber vier, Elektronenholographiemessschritte nacheinander bei gleichen Periodenlängen des Anregungssignals durchzuführen. Dies wird nachfolgend näher im Zusammenhang mit der Figur 10 erläutert.

Die somit generierten Elektronenhologramme EHG werden von der Phasenbildungseinheit 30 in Phasenbilder PB rekonstruiert und mit der Auswerteeinheit 40 Steigungswerte dφ/dx ermittelt.

Die Figur 10 zeigt ein Ausführungsbeispiel für eine Analyse der Steigungswerte dφ/dx bei äquidistanten Messfensterpositionen zur Ermittlung des betragsmäßig höchsten Steigungswertes Max|dφ|dx| durch eine Sortiereinheit 45.

Die Sortiereinheit 45 analysiert die ermittelten

Steigungswerte dφ/dx bei äquidistanten Messfensterpositionen und ermittelt den betragsmäßig höchsten Steigungswert Max|dφ/dx|.

Der betragsmäßig höchste Steigungswert Max|dφ/dx| kann unmittelbar als Messwert der Anordnung 6 ausgegeben werden. Alternativ oder zusätzlich kann - wie bei dem Ausführungsbeispiel gemäß Figur 9 - der betragsmäßig höchste Steigungswert Max|dφ/dx| an den Multiplizierer 50 weitergegeben werden.

Im Übrigen sei bezüglich der Arbeitsweise der Messfenstersteuereinheit 80 auf die obigen Erläuterungen im Zusammenhang mit den Figuren 1 bis 10 verwiesen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.

Bezugszeichenliste

| 5 | Anordnung |
| 6 | alternative Anordnung |
| 10 | Sinusgenerator |
| 20 | Elektronenholographiemessgerät |
| 21 | Elektronenquelle |
| 22 | Messeinheit |
| 30 | Phasenbilderzeugungseinheit |
| 40 | Auswerteinheit |
| 45 | Sortiereinheit |
| 50 | Multiplizierer |
| 60 | Quotientenbilder |
| 70 | Steuereinrichtung |
| 80 | Messfenstersteuereinheit |
| 100 | Bauelement |
| 110 | Spalt |
| 120 | Leiterbahn |
| 130 | Leiterbahn |
| 131 | Ausnehmung |

| C | Kapazität |
| D | Spaltbreite |
| E | elektrisches Feld |
| EHG | Elektronenhologramm |
| f | Anregungsfrequenz |
| F | Messfenster |
| K | Konstante |
| M | Messwert |
| Max | Maximum |
| Min | Minimum |
| PB | Phasenbild |
| Se | Elektronenstrahl |
| Sr | Referenzelektronenstrahl |
| ST(f) | Steuersignal |
| T | Periodendauer |

| Tf | zeitliche Länge |
| U0 | Spannungsamplitude |
| Ua | Bauelementspannung |
| Ue | Anregungssignal |
| Uoffset | Gleichanteil |
| VG(f) | Frequenzgang |
| x | Ort |

| φ | Phase |
| dφ/dx | Steigungswert |
| Max(|dφ/dx|) | maximaler Steigungswert |

**Patentansprüche**

1. Verfahren zum Erfassen eines Messwerts (dφ/dx, M),
   wobei

   - ein elektrisches Anregungssignal (Ue) mit einer vorgegebenen Anregungsfrequenz (f), mit oder ohne überlagerten Gleichanteil (Uoffset), an einem Eingang eines Bauelements (100, C), das auf das elektrische Anregungssignal (Ue) reagiert und eine Eigenschaft in Abhängigkeit von dem Anregungssignal in messbarem Umfange für Elektronenholographie verändert, eingespeist wird,
   - zumindest ein Elektronenholographiemessschritt durchgeführt wird, bei dem

       - auf das Bauelement (100, C) ein Elektronenstrahl (Se) gerichtet wird, der das Bauelement (100, C) durchdringt und/oder passiert und anschließend mit einem Referenzelektronenstrahl (Sr) überlagert wird, und
       - ein durch Interferenz der zwei Elektronenstrahlen (Se, Sr) während eines vorgegebenen Messfensters (F) entstehendes Elektronenhologramm (EHG) gemessen und daraus ein Phasenbild (PB) ermittelt wird, und

   - anhand des Phasenbildes (PB) der Messwert (M) gebildet wird,
   - wobei die zeitliche Länge (Tf) des Messfensters (F) des Elektronenholographiemessschritts kleiner ist als die Hälfte der Periodendauer (T) des elektrischen Anregungssignals (Ue),
   **dadurch gekennzeichnet, dass**
   - als das Anregungssignal ein sinusförmiges elektrisches Anregungssignal (Ue) an dem Eingang des Bauelements (100, C) eingespeist wird,
   - zumindest zwei Elektronenholographiemessschritte der beschriebenen Art nacheinander mit unterschiedlichen Anregungsfrequenzen (f) durchgeführt werden,

- bei jedem der Elektronenholographiemessschritte die Länge (Tf) des Messfensters (F) und die jeweilige Periodenlänge (T) des sinusförmigen Anregungssignals (Ue) aneinander angepasst werden, und zwar derart, dass das Verhältnis zwischen der Länge (Tf) des Messfensters (F) und der jeweiligen Periodenlänge (T) des Anregungssignals (Ue) bei allen Elektronenholographiemessschritten gleich groß ist, und
- bei jedem der Elektronenholographiemessschritte - unabhängig von der jeweiligen Anregungsfrequenz (f) - die Lage der Messfenster (F) bezogen auf den zeitlichen Verlauf des Anregungssignals (Ue) stets gleich ist.

2. Verfahren nach Anspruch 1,
   **dadurch gekennzeichnet, dass**
   die Lage des Messfensters (F) relativ zu den Stellen maximaler Steigung des Anregungssignals (Ue) derart gewählt wird, dass das Messfenster (F) zwischen diesen Stellen liegt und diese nicht einschließt.

3. Verfahren nach einem der voranstehenden Ansprüche,
   **dadurch gekennzeichnet, dass**
   die Lage des Messfensters (F) derart gewählt wird, dass es eine Extremstelle, also entweder ein Maximum (Max) oder ein Minimum (Min), des Anregungssignals (Ue) erfasst.

4. Verfahren nach einem der voranstehenden Ansprüche,
   **dadurch gekennzeichnet, dass**
   die Lage des Messfensters (F) derart gewählt wird, dass die Fenstermitte an der oder zumindest im Bereich der Extremstelle des Anregungssignals (Ue) liegt.

5. Verfahren nach einem der voranstehenden Ansprüche,
   **dadurch gekennzeichnet, dass**
   bei jedem der Elektronenholographiemessschritte - unabhängig von der jeweiligen Anregungsfrequenz (f) - die Fenstermitte stets an der oder zumindest im Bereich der ausgewählten Extremstelle des Anregungssignals (Ue) liegt.

6. Verfahren nach einem der voranstehenden Ansprüche,
   **dadurch gekennzeichnet, dass**
   anhand des Phasenbildes (PB) die Änderung der Phase über dem Ort (x) durch Ableitung der Phase nach dem Ort unter Bildung eines Steigungswerts ($d\varphi/dx$) ermittelt wird und als der Messwert (M) der Steigungswert ($d\varphi/dx$) ausgegeben wird oder mit dem Steigungswert ($d\varphi/dx$) der Messwert (M)) gebildet wird, insbesondere durch Multiplikation mit einer Konstante (K).

7. Verfahren nach einem der voranstehenden Ansprüche,
   **dadurch gekennzeichnet, dass**

   als Messwert (M) die an dem Bauelement (100, C) anliegende elektrische Spannung ermittelt wird oder
   als Messwert (M) der durch das Bauelement (100, C) fließende Strom ermittelt wird.

8. Verfahren nach einem der voranstehenden Ansprüche,
   **dadurch gekennzeichnet, dass**

   die zeitliche Länge (Tf) des Messfensters (F) kleiner ist als ein Fünftel der Periodendauer (T) des Anregungssignals (Ue), insbesondere kleiner als ein Achtel, vorzugsweise kleiner als ein Zehntel und besonders bevorzugt kleiner als ein Zwanzigstel der Periodendauer (T) des Sinussignals oder
   die zeitliche Länge (Tf) des Messfensters (F) im Bereich zwischen einem Zwanzigstel und einem Hundertstel der Periodendauer (T) des Sinussignals liegt.

9. Verfahren nach einem der voranstehenden Ansprüche, **dadurch gekennzeichnet, dass**

   - eine Vielzahl an Elektronenholographiemessschritten der beschriebenen Art nacheinander mit unterschiedlichen Anregungsfrequenzen (f) durchgeführt wird und
   - in jedem Elektronenholographiemessschritt jeweils ein Verhältniswert zwischen der Amplitude (U0) des Wechselanteils des sinusförmigen Anregungssignals (Ue) und dem Messwert (M) errechnet wird und
   - mit den Verhältniswerten (V) ein Frequenzgang (VG(f)) des Bauelements (100, C) ermittelt wird.

10. Anordnung zum Erfassen eines Messwerts (M), **gekennzeichnet durch**

    - einen Generator (10), der ein elektrisches Anregungssignal (Ue) mit einer vorgegebenen Anregungsfrequenz (f), mit oder ohne überlagerten Gleichanteil (Uoffset), erzeugen und in ein auf das elektrische Anregungssignal (Ue) reagierendes und eine Eigenschaft in Abhängigkeit von dem Anregungssignal in messbarem Umfange für Elektronenholographie veränderndes Bauelement (100, C) einspeisen kann,
    - ein Elektronenholographiemessgerät (20) zur Durchführung eines Elektronenholographiemessschritts, bei dem

- auf das Bauelement (100, C) ein Elektronenstrahl (Se) gerichtet wird, der das Bauelement (100, C) durchdringt und/oder passiert und anschließend mit einem Referenzelektronenstrahl (Sr) überlagert wird, und
- ein durch Interferenz der zwei Elektronenstrahlen während eines vorgegebenen Messfensters (F) entstehendes Elektronenhologramm (EHG) gemessen und daraus ein Phasenbild (PB) ermittelt wird,

- eine Auswerteinheit (40) zur Bildung des Messwertes anhand des Phasenbildes (PB), und
- eine Messfenstersteuereinheit (80), die derart ausgebildet ist, dass sie die Lage und Länge (Tf) des Messfensters (F) bestimmt, und zwar derart, dass die zeitliche Länge (Tf) des Messfensters (F) des Elektronenholographiemessschritts kleiner ist als die Hälfte der Periodendauer (T) des Anregungssignals (Ue),

**dadurch gekennzeichnet, dass**
- der Generator (10) ein Sinusgenerator ist, der ein sinusförmiges Anregungssignal (Ue) mit einer vorgegebenen Anregungsfrequenz (f), mit oder ohne überlagerten Gleichanteil (Uoffset), erzeugen und in das auf das elektrische Anregungssignal (Ue) reagierende Bauelement (100, C) einspeisen kann,
- die Messfenstersteuereinheit (80) derart ausgebildet ist, dass sie für mehrere Elektronenholographiemessschritte nacheinander mit unterschiedlichen Periodenlängen des Anregungssignals (Ue) bei jedem Elektronenholographiemessschritt jeweils die Länge (Tf) des Messfensters (F) an die jeweilige Periodenlänge (T) des Anregungssignals (Ue) anpasst, und zwar derart, dass das Verhältnis zwischen der Länge (Tf) des Messfensters (F) und der jeweiligen Periodenlänge (T) des Anregungssignals (Ue) bei allen Elektronenholographiemessschritten gleich groß ist, und
- die Messfenstersteuereinheit (80) derart ausgebildet ist, dass sie für mehrere Elektronenholographiemessschritte nacheinander mit unterschiedlichen Periodenlängen des Anregungssignals (Ue) bei jedem Elektronenholographiemessschritt jeweils die Lage des Messfensters (F) an die jeweilige Periodenlänge (T) des Anregungssignals (Ue) anpasst, und zwar derart, dass die Lage des Messfensters (F) bezogen auf den zeitlichen Verlauf des Anregungssignals (Ue) bei allen Elektronenholographiemessschritten gleich ist.

11. Anordnung nach Anspruch 10,
    **dadurch gekennzeichnet, dass**

die Messfenstersteuereinheit (80) derart ausgebildet ist, dass sie die Lage des Messfensters (F) relativ zu den Stellen maximaler Steigung des Anregungssignals (Ue) derart wählt, dass das Messfenster (F) zwischen diesen Stellen liegt und diese nicht einschließt.

12. Anordnung nach einem der voranstehenden Ansprüche 10 bis 11,
    **dadurch gekennzeichnet, dass**

    - die Messfenstersteuereinheit (80) derart ausgebildet ist, dass sie die Lage des Messfensters (F) derart wählt, dass das Messfenster (F) eine Extremstelle, also entweder ein Maximum (Max) oder ein Minimum (Min), des Anregungssignals (Ue) erfasst.

13. Anordnung nach einem der voranstehenden Ansprüche 10 bis 12,
    **dadurch gekennzeichnet, dass**

    - die Messfenstersteuereinheit (80) derart ausgebildet ist, dass sie die Lage des Messfensters (F) derart wählt, dass die Fenstermitte an der oder zumindest im Bereich einer Extremstelle des Anregungssignals (Ue) liegt.

14. Anordnung nach einem der voranstehenden Ansprüche 10 bis 13,
    **dadurch gekennzeichnet, dass**
    die Auswerteinheit (40) derart ausgebildet ist, dass sie anhand des Phasenbildes (PB) durch Ableitung der Phase nach dem Ort die Änderung der Phase ($\varphi$) über dem Ort (x) unter Bildung eines Steigungswerts ($d\varphi/dx$) ermittelt und als Messwert (M) den Steigungswert ($d\varphi/dx$) ausgibt oder mit dem Steigungswert ($d\varphi/dx$) den Messwert (M) bildet, insbesondere durch Multiplikation mit einer Konstante (K).

**Claims**

1. Method for recording a measurement value ($d\varphi/dx$, M), wherein

   - an electrical excitation signal (Ue) having a predetermined excitation frequency (f), with or without a superimposed DC part (Uoffset), is fed to an input of a component (100, C) which responds to the electrical excitation signal (Ue) and varies a property to a measurable extent for electron holography as a function of the excitation signal,
   - at least one electron holography measurement step is carried out, in which
   - an electron beam (Se) is directed onto the component (100, C), penetrates and/or passes through the component (100, C) and is subsequently superimposed with a reference electron beam (Sr), and

- an electron hologram (EHG) resulting from interference of the two electron beams (Se, Sr) during a predetermined measurement window (F) is measured, and a phase image (PB) is determined therefrom, and

- the measurement value (M) is formed with the aid of the phase image (PB),

- wherein the temporal length (Tf) of the measurement window (F) of the electron holography measurement step is less than half the period duration (T) of the electrical excitation signal (Ue),

**characterized in that**

- a sinusoidal electrical excitation signal (Ue) is fed to the input of the component (100, C) as the excitation signal,

- at least two electron holography measurement steps of the type described are carried out successively with different excitation frequencies (f),

- in each of the electron holography measurement steps, the length (Tf) of the measurement window (F) and the respective period length (T) of the sinusoidal excitation signal (Ue) are adapted to one another, specifically in such a way that the ratio between the length (Tf) of the measurement window (F) and the respective period length (T) of the excitation signal (Ue) is equally large for all electron holography measurement steps, and

- in each of the electron holography measurement steps - independently of the respective excitation frequency (f)

- the location of the measurement window (F) in relation to the time profile of the excitation signal (Ue) is always the same.

2. Method according to Claim 1,
**characterized in that**
the location of the measurement window (F) relative to the points of maximum gradient of the excitation signal (Ue) is selected in such a way that the measurement window (F) lies between these points and does not include them.

3. Method according to either of the preceding claims,
**characterized in that**
the location of the measurement window (F) is selected in such a way that it records an extremum, i.e. either a maximum (Max) or a minimum (Min), of the excitation signal (Ue).

4. Method according to one of the preceding claims,
**characterized in that**
the location of the measurement window (F) is selected in such a way that the window centre lies at or at least in the region of the extremum of the excitation signal (Ue) .

5. Method according to one of the preceding claims,
**characterized in that**
in each of the electron holography measurement steps - independently of the respective excitation frequency (f)

- the window centre always lies at or at least in the region of the selected extremum of the excitation signal (Ue) .

6. Method according to one of the preceding claims,
**characterized in that**
the variation of the phase as a function of the position (x) is determined by forming a gradient value (dφ/dx) with the aid of the phase image (PB) by differentiating the phase with respect to the position, and the gradient value (dφ/dx) is output as the measurement value (M) or the measurement value (M) is formed with the gradient value (dφ/dx), in particular by multiplication by a constant (K).

7. Method according to one of the preceding claims,
**characterized in that**

the voltage applied to the component (100, C) is determined as the measurement value (M) or the current flowing through the component (100, C) is determined as the measurement value (M).

8. Method according to one of the preceding claims,
**characterized in that**

the temporal length (Tf) of the measurement window (F) is less than one fifth of the period duration (T) of the excitation signal (Ue), in particular less than one eighth, preferably less than one tenth and particularly preferably less than one twentieth of the period duration (T) of the sine signal or
the temporal length (Tf) of the measurement window (F) lies in the range of between one twentieth and one hundredth of the period duration (T) of the sine signal.

9. Method according to one of the preceding claims,
**characterized in that**

- a multiplicity of electron holography measurement steps of the type described are carried out successively with different excitation frequencies (f), and
- in each electron holography measurement step, a ratio value between the amplitude (U0) of the AC part of the sinusoidal excitation signal (Ue) and the measurement value (M) is calculated in each case, and
- a frequency response (VG(f)) of the component (100, C) is determined with the aid of the ratio values (V).

10. Arrangement for recording a measurement value (M), **characterized by**

- a generator (10) which can generate an electrical excitation signal (Ue) having a predetermined excitation frequency (f), with or without a superimposed DC part (Uoffset), and feed it to a component (100, C) which responds to the electrical excitation signal (Ue) and varies a property to a measurable extent for electron holography as a function of the excitation signal,
- an electron holography measuring instrument (20) for carrying out an electron holography measurement step, in which
- an electron beam (Se) is directed onto the component (100, C), penetrates and/or passes through the component (100, C) and is subsequently superimposed with a reference electron beam (Sr), and
- an electron hologram (EHG) resulting from interference of the two electron beams during a predetermined measurement window (F) is measured, and a phase image (PB) is determined therefrom,
- an evaluation unit (40) for forming the measurement value with the aid of the phase image (PB), and
- a measurement window control unit (80), which is configured in such a way that it determines the location and length (Tf) of the measurement window (F), specifically in such a way that the temporal length (Tf) of the measurement window (F) of the electron holography measurement step is less than half the period duration (T) of the excitation signal (Ue),
**characterized in that**
- the generator (10) is a sine generator which can generate a sinusoidal excitation signal (Ue) having a predetermined excitation frequency (f), with or without a superimposed DC part (Uoffset), and feed it to the component (100, C) which responds to the electrical excitation signal (Ue),
- the measurement window control unit (80) is configured in such a way that, for a plurality of electron holography measurement steps successively with different period lengths of the excitation signal (Ue), in each electron holography measurement step it respectively adapts the length (Tf) of the measurement window (F) to the respective period length (T) of the excitation signal (Ue), specifically in such a way that the ratio between the length (Tf) of the measurement window (F) and the respective period length (T) of the excitation signal (Ue) is equally large for all electron holography measurement steps, and
- the measurement window control unit (80) is configured in such a way that, for a plurality of electron holography measurement steps successively with different period lengths of the excitation signal (Ue), in each electron holography measurement step it respectively adapts the location of the measurement window (F) to the respective period length (T) of the excitation signal (Ue), specifically in such a way that the location of the measurement window (F) in relation to the time profile of the excitation signal (Ue) is the same for all electron holography measurement steps.

11. Arrangement according to Claim 10,
**characterized in that**
the measurement window control unit (80) is configured in such a way that it selects the location of the measurement window (F) relative to the points of maximum gradient of the excitation signal (Ue) in such a way that the measurement window (F) lies between these points and does not include them.

12. Arrangement according to one of the preceding Claims 10 to 11,
**characterized in that**

- the measurement window control unit (80) is configured in such a way that it selects the location of the measurement window (F) in such a way that the measurement window (F) records an extremum, i.e. either a maximum (Max) or a minimum (Min), of the excitation signal (Ue).

13. Arrangement according to one of the preceding Claims 10 to 12,
**characterized in that**

- the measurement window control unit (80) is configured in such a way that it selects the location of the measurement window (F) in such a way that the window centre lies at or at least in the region of an extremum of the excitation signal (Ue).

14. Arrangement according to one of the preceding Claims 10 to 13,
**characterized in that**
the evaluation unit (40) is configured in such a way that it determines the variation of the phase ($\varphi$) as a function of the position (x) by forming a gradient value ($d\varphi/dx$) with the aid of the phase image (PB) by differentiating the phase with respect to the position, and outputs the gradient value ($d\varphi/dx$) as the meas-

urement value (M) or forms the measurement value (M) with the gradient value (dφ/dx), in particular by multiplication by a constant (K).

**Revendications**

1. Procédé permettant de détecter une valeur de mesure (dφ/dx, M), dans lequel

   - un signal d'excitation électrique (Ue) avec une fréquence d'excitation prédéfinie (f), avec ou sans composante continue superposée (Uoffset), est injecté à une entrée d'un composant (100, C) qui est sensible au signal d'excitation électrique (Ue) et modifie une propriété en fonction du signal d'excitation dans une proportion mesurable pour l'holographie électronique,
   - au moins une étape de mesure par holographie électronique est effectuée, dans laquelle

      - un faisceau électronique (Se) est dirigé sur le composant (100, C) et traverse ou passe par le composant (100, C) et est ensuite superposé avec un faisceau électronique de référence (Sr), et
      - un hologramme électronique (EHG) créé par l'interférence des deux faisceaux électroniques (Se, Sr) pendant une fenêtre de mesure prédéfinie (F) est mesuré et une image de phase (PB) est établie à partir de celui-ci, et

   - la valeur de mesure (M) est formée à l'aide de l'image de phase (PB),
   - dans lequel la longueur temporelle (Tf) de la fenêtre de mesure (F) de l'étape de mesure par holographie électronique est inférieure à la moitié de la durée de période (T) du signal d'excitation électrique (Ue),
   **caractérisé en ce que**
   - un signal d'excitation électrique (Ue) sinusoïdal est injecté comme signal d'excitation à l'entrée du composant (100, C),
   - au moins deux étapes de mesure par holographie électronique du type décrit sont effectuées l'une après l'autre avec différentes fréquences d'excitation (f),
   - à chacune des étapes de mesure par holographie électronique, la longueur (Tf) de la fenêtre de mesure (F) et la longueur de période (T) respective du signal d'excitation (Ue) sinusoïdal sont adaptées l'une à l'autre, notamment de telle sorte que le rapport entre la longueur (Tf) de la fenêtre de mesure (F) et la longueur de période (T) respective du signal d'excitation (Ue) est identique à toutes les étapes de mesure par holographie électronique, et

   - à chacune des étapes de mesure par holographie électronique - indépendamment de la fréquence d'excitation (f) respective - la position de la fenêtre de mesure (F) est toujours identique par rapport à la courbe dans le temps du signal d'excitation (Ue).

2. Procédé selon la revendication 1, **caractérisé en ce que** la position de la fenêtre de mesure (F) par rapport aux points de pente maximale du signal d'excitation (Ue) est choisie de telle sorte que la fenêtre de mesure (F) se situe entre ces points et ne les inclut pas.

3. Procédé selon l'une quelconque des revendications précédentes, **caractérisé en ce que** la position de la fenêtre de mesure (F) est choisie de telle sorte qu'elle englobe un point extrême, donc soit un maximum (Max), soit un minimum (Min), du signal d'excitation (Ue).

4. Procédé selon l'une quelconque des revendications précédentes, **caractérisé en ce que** la position de la fenêtre de mesure (F) est choisie de telle sorte que le centre de la fenêtre se trouve au point extrême du signal d'excitation (Ue) ou du moins au niveau de celui-ci.

5. Procédé selon l'une quelconque des revendications précédentes, **caractérisé en ce qu'**à chacune des étapes de mesure par holographie électronique - indépendamment de la fréquence d'excitation (f) respective - le centre de la fenêtre se trouve toujours au point extrême sélectionné du signal d'excitation (Ue) ou du moins au niveau de celui-ci.

6. Procédé selon l'une quelconque des revendications précédentes, **caractérisé en ce que** l'image de phase (PB) permet d'établir la variation de la phase à l'endroit (x) par dérivation de la phase après l'endroit en formant une valeur de pente (dφ/dx), et la valeur de pente (dφ/dx) est sortie comme valeur de mesure (M), ou la valeur de mesure (M) est formée avec la valeur de pente (dφ/dx), en particulier par multiplication par une constante (K).

7. Procédé selon l'une quelconque des revendications précédentes, **caractérisé en ce que**

   la tension électrique appliquée au composant (100, C) est établie en tant que valeur de mesure (M), ou
   le courant circulant par le composant (100, C) est établi en tant que valeur de mesure (M).

8. Procédé selon l'une quelconque des revendications précédentes, **caractérisé en ce que**

la longueur temporelle (Tf) de la fenêtre de mesure (F) est inférieure à un cinquième de la durée de période (T) du signal d'excitation (Ue), en particulier inférieure à un huitième, de préférence inférieure à un dixième, et de manière particulièrement préférée inférieure à un vingtième de la durée de période (T) du signal sinusoïdal, ou

la longueur temporelle (Tf) de la fenêtre de mesure (F) est située dans la plage entre un vingtième et un centième de la durée de période (T) du signal sinusoïdal.

9. Procédé selon l'une quelconque des revendications précédentes, **caractérisé en ce que**

   - une pluralité d'étapes de mesure par holographie électronique du type décrit sont effectuées les unes après les autres avec différentes fréquences d'excitation (f), et
   - à chaque étape de mesure par holographie électronique, respectivement un rapport entre l'amplitude (U0) de la composante alternative du signal d'excitation (Ue) sinusoïdal et la valeur de mesure (M) est calculé, et
   - une réponse en fréquence (VG(f)) du composant (100, C) est établie à l'aide des rapports (V).

10. Agencement permettant de détecter une valeur de mesure (M), **caractérisé par**

    - un générateur (10) qui peut générer un signal d'excitation électrique (Ue) avec une fréquence d'excitation prédéfinie (f), avec ou sans composante continue superposée (Uoffset), et l'injecter dans un composant (100, C) qui est sensible au signal d'excitation électrique (Ue) et modifie une propriété en fonction du signal d'excitation dans une proportion mesurable pour l'holographie électronique,
    - un appareil de mesure par holographie électronique (20) pour effectuer une étape de mesure par holographie électronique, dans laquelle

      - un faisceau électronique (Se) est dirigé sur le composant (100, C) et traverse ou passe par le composant (100, C) et est ensuite superposé avec un faisceau électronique de référence (Sr), et
      - un hologramme électronique (EHG) crée par l'interférence des deux faisceaux électroniques pendant une fenêtre de mesure prédéfinie (F) est mesuré et une image de phase (PB) est établie à partir de celui-ci, et

    - une unité d'évaluation (40) pour former la valeur de mesure à l'aide de l'image de phase (PB), et

    - une unité de commande de fenêtre de mesure (80) qui est réalisée de telle sorte qu'elle détermine la position et la longueur (Tf) de la fenêtre de mesure (F), et notamment de telle sorte que la longueur temporelle (Tf) de la fenêtre de mesure (F) de l'étape de mesure par holographie électronique est inférieure à la moitié de la durée de période (T) du signal d'excitation (Ue), **caractérisé en ce que**
    - le générateur (10) est un générateur sinusoïdal qui peut générer un signal d'excitation (Ue) sinusoïdal avec une fréquence d'excitation prédéfinie (f), avec ou sans composante continue superposée (Uoffset), et l'injecter dans le composant (100, C) sensible au signal d'excitation électrique (Ue),
    - l'unité de commande de fenêtre de mesure (80) est réalisée de telle sorte qu'elle adapte pour plusieurs étapes de mesure par holographie électronique les unes après les autres avec différentes longueurs de période du signal d'excitation (Ue) à chaque étape de mesure par holographie électronique respectivement la longueur (Tf) de la fenêtre de mesure (F) à la longueur de période (T) respective du signal d'excitation (Ue), notamment de telle sorte que le rapport entre la longueur (Tf) de la fenêtre de mesure (F) et la longueur de période (T) respective du signal d'excitation (Ue) est identique à toutes les étapes de mesure par holographie électronique, et
    - l'unité de commande de fenêtre de mesure (80) est réalisée de telle sorte qu'elle adapte pour plusieurs étapes de mesure par holographie électronique les unes après les autres avec différentes longueurs de période du signal d'excitation (Ue) à chaque étape de mesure par holographie électronique respectivement la position de la fenêtre de mesure (F) à la longueur de période (T) respective du signal d'excitation (Ue), notamment de telle sorte que la position de la fenêtre de mesure (F) par rapport à la courbe dans le temps du signal d'excitation (Ue) est identique à toutes les étapes de mesure par holographie électronique.

11. Agencement selon la revendication 10, **caractérisé en ce que** l'unité de commande de fenêtre de mesure (80) est réalisée de telle sorte qu'elle choisit la position de la fenêtre de mesure (F) par rapport aux points de pente maximale du signal d'excitation (Ue) de telle sorte que la fenêtre de mesure (F) se situe entre ces points et ne les inclut pas.

12. Agencement selon l'une quelconque des revendications précédentes 10 à 11, **caractérisé en ce que**

    - l'unité de commande de fenêtre de mesure (80) est réalisée de telle sorte qu'elle choisit la position de la fenêtre de mesure (F) de telle sorte que la fenêtre de mesure (F) englobe un point extrême, donc soit un maximum (Max), soit un minimum (Min), du signal d'excitation (Ue).

13. Agencement selon l'une quelconque des revendications précédentes 10 à 12, **caractérisé en ce que**

- l'unité de commande de fenêtre de mesure (80) est réalisée de telle sorte qu'elle choisit la position de la fenêtre de mesure (F) de telle sorte que le centre de la fenêtre se trouve au point extrême du signal d'excitation (Ue) ou du moins au niveau de celui-ci.

14. Agencement selon l'une quelconque des revendications précédentes 10 à 13, **caractérisé en ce que** l'unité d'évaluation (40) est réalisée de telle sorte qu'elle établit à l'aide de l'image de phase (PB), par dérivation de la phase après l'endroit, la variation de la phase ($\varphi$) à l'endroit (x), en formant une valeur de pente (d$\varphi$/dx), et sort la valeur de pente (d$\varphi$/dx) en tant que valeur de mesure (M), ou forme la valeur de mesure (M) avec la valeur de pente (dcp/dx), en particulier par multiplication par une constante (K) .

Fig.1

Fig. 2

EP 3 837 587 B1

Fig. 3

Fig. 5

EP 3 837 587 B1

Fig. 4

EP 3 837 587 B1

Fig. 6

Fig. 7

EP 3 837 587 B1

Fig. 8

Fig.9

EP 3 837 587 B1

Fig. 10

EP 3 837 587 B1

# EP 3 837 587 B1

## IN DER BESCHREIBUNG AUFGEFÜHRTE DOKUMENTE

**In der Beschreibung aufgeführte Nicht-Patentliteratur**

- Gated interference for time-resolved electron holography. **T. NIERMANN ; M. LEHMANN ; T. WAGNER.** Ultramicroscopy. 2017, vol. 182, 54-61
- **V. MIGUNOV et al.** Prospects for quantitative and time-resolved double and continuous exposure off-axis electron holography. *Ultramicroscopy,* 2016, vol. 178, 48-61
- **T. NIERMANN ; M. LEHMANN ; T. WAGNER.** Gated interference for time-resolved electron holography. *Ultramicroscopy,* 2017, vol. 182, 54-61